# EUROPEAN PATENT APPLICATION

(11) **EP 2 843 691 A1**
(43) Date of publication of application: **04.03.2015**
(21) Application number: 12875369.6
(22) Date of filing: 27.04.2012
(51) Int. Cl.: H01L 21/338, H01L 21/822, H01L 21/8232, H01L 27/04, H01L 27/06, H01L 27/095, H01L 29/778, H01L 29/812, H03F 3/16

(54) **FET CHIP**

(71) Applicant: Mitsubishi Electric Corporation, Tokyo 100-8310 (JP)
(72) Inventor: OTSUKA, Hiroshi, Tokyo 100-8310 (JP); OISHI, Toshiyuki, Tokyo 100-8310 (JP); KUWATA, Eigo, Tokyo 100-8310 (JP); YAMASAKI, Takashi, Tokyo 100-8310 (JP); KIMURA, Makoto, Tokyo 100-8310 (JP); NAKAYAMA, Masatoshi, Tokyo 100-8310 (JP)
(74) Representative: Pfenning, Meinig & Partner GbR
(86) International application number: PCT/JP2012/002916
(87) International publication number: WO 2013/160962

(57) **Abstract**

An FET chip is configured to include an oscillation suppression circuit that has a gate capacitance C formed between a gate electrode 5c and two-dimensional electron gas, and a channel resistance R between the gate electrode 5c and a source electrode 7c, and therefore the oscillation suppression circuit is loaded by only an FET process to make an MMIC design unnecessary, so that it is possible to attain stabilization of an FET while suppressing increase in cost, and to suppress oscillation.

## Description

### TECHNICAL FIELD

The present invention relates to an FET chip that is mainly used in a VHF band, a UHF band, a microwave band, and a millimeter wave band.

### BACKGROUND ART

In general high output amplifiers, in order to obtain a high output, FETs (Field Effect Transistors) are combined in parallel to be used as shown in Fig. 21 (e.g., see Patent Document 1 below).

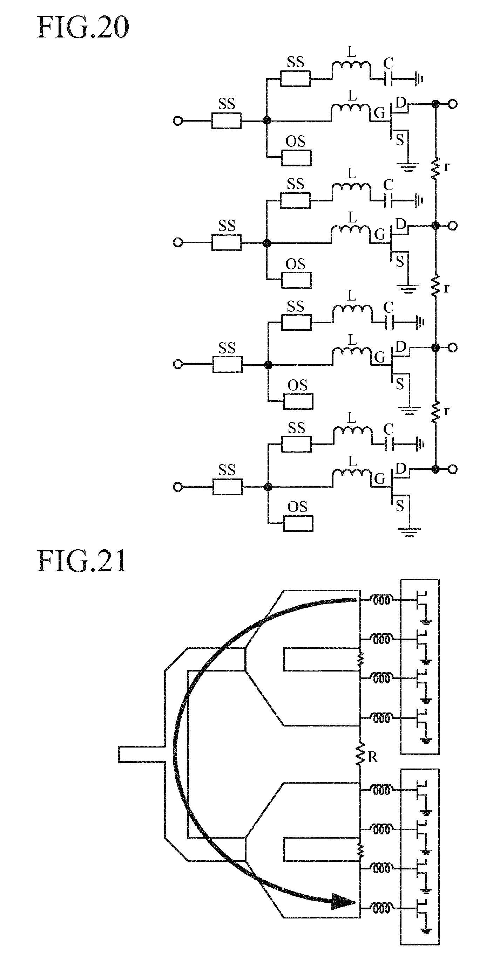

In this case, loop oscillation shown by an arrow in Fig. 21 sometimes occurs.

In order to suppress this, an isolation resistor R (central part in Fig. 21) is used.

However, in a case where an FET chip is made large in order to obtain the high output, a distance from an outermost FET cell to the isolation resistor R is increased, and therefore oscillation is unlikely to be suppressed.

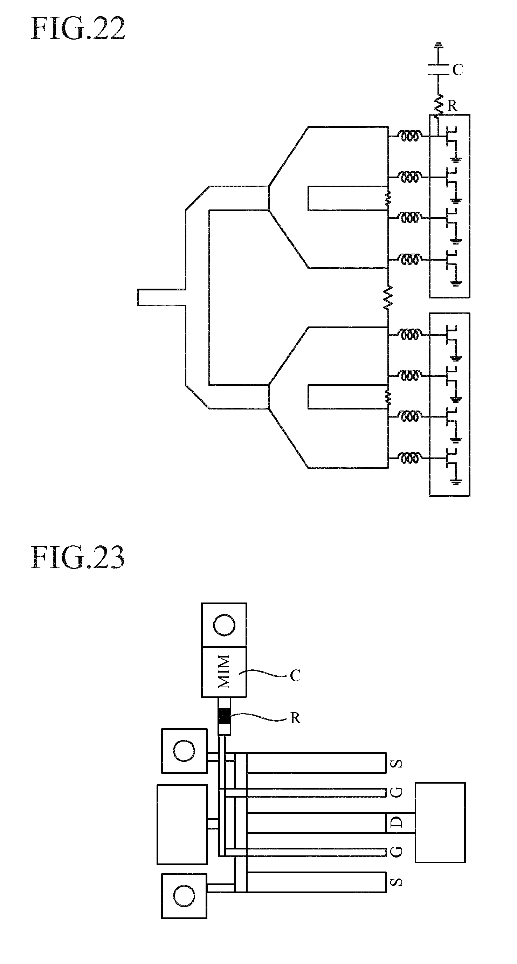

As a countermeasure against the above, a method of improving stabilization of FETs by loading an RC circuit on an outermost FET cell is used as shown in Fig. 22.

### PRIOR ART DOCUMENTS

### PATENT DOCUMENTS

Patent Document 1: Japanese Patent Application Laid-open No. H8-32376

### SUMMARY OF THE INVENTION

### PROBLEMS TO BE SOLVED BY THE INVENTION

Like the conventional technology, a configuration in which an RC circuit is loaded on an outermost FET cell is effective for suppression of the oscillation.

However, as shown in Fig. 23, an MMIC (Monolithic-Microwave-Integrated-Circuits) design of an FET chip has to be carried out in order to implement the RC circuit; thus, there is a problem such that the number of processes is increased, resulting in increase in cost.

The present invention has been conceived in order to solve the aforementioned problem, and an object of the invention is to obtain an FET chip that suppresses the oscillation without the increase in cost.

### MEANS FOR SOLVING THE PROBLEMS

An FET chip of the present invention includes: a first gate electrode that is connected to a gate pad; a second gate electrode that is connected to the gate pad; a drain electrode that is connected to a drain pad; a first source electrode that is connected to a first source pad grounded through a first via hole; a second source electrode that is connected to a second source pad grounded through a second via hole; an FET cell that includes the first gate electrode, the drain electrode, and the first source electrode; an isolation implantation part that electrically isolates the first gate electrode, the drain electrode, and the first source electrode from the second gate electrode, and the second source electrode; and an oscillation suppression circuit that includes a gate capacitance formed between the second gate electrode and two-dimensional electron gas, and a channel resistance between the second gate electrode and the second source electrode.

### EFFECT OF THE INVENTION

According to the invention, an oscillation suppression circuit is loaded by only an FET process to make an MMIC design unnecessary, so that it is possible to achieve stabilization of an FET while suppressing increase in cost, and to suppress oscillation.

Moreover, no current flows between the first gate electrode, drain electrode and first source electrode, and the second gate electrode and second source electrode by the isolation implantation part, and an occurrence of an unnecessary gate capacitance and/or channel resistance is suppressed, which provides an advantageous effect that can achieve the stabilization of the FET.

### BRIEF DESCRIPTION OF THE DRAWINGS

Fig. 1 is a layout diagram showing an FET chip according to Embodiment 1 of the present invention.
Fig. 2 is a sectional view showing the FET chip.
Fig. 3 is an equivalent circuit diagram of the FET chip.
Fig. 4 is a layout diagram showing an FET chip according to Embodiment 2 of the invention.
Fig. 5 is an equivalent circuit diagram of the FET chip.
Fig. 6 is a layout diagram showing an FET chip according to Embodiment 3 of the invention.
Fig. 7 is a layout diagram showing an FET chip according to Embodiment 4 of the invention.
Fig. 8 is a sectional view showing the FET chip.
Fig. 9 is an equivalent circuit diagram of the FET chip.
Fig. 10 is a layout diagram showing an FET chip according to Embodiment 5 of the invention.
Fig. 11 is an equivalent circuit diagram of the FET chip.
Fig. 12 is a layout diagram showing an FET chip according to Embodiment 6 of the invention.
Fig. 13 is a layout diagram showing an FET chip according to Embodiment 7 of the invention.
Fig. 14 is an equivalent circuit diagram of the FET chip.
Fig. 15 is a layout diagram showing an FET chip according to Embodiment 8 of the invention.
Fig. 16 is an equivalent circuit diagram of the FET chip.
Fig. 17 is a layout diagram showing an FET chip according to Embodiment 9 of the invention.
Fig. 18 is an equivalent circuit diagram of the FET chip.
Fig. 19 is a layout diagram showing an FET chip according to Embodiment 10 of the invention.
Fig. 20 is an equivalent circuit diagram of the FET chip.
Fig. 21 is an explanatory diagram showing a FET chip and a synthetic circuit in a conventional technology.
Fig. 22 is an explanatory diagram showing a FET chip and a synthetic circuit in a conventional technology.
Fig. 23 is an explanatory diagram showing an FET chip using a conventional MMIC technology.

### BEST MODE FOR CARRYING OUT THE INVENTION

In the following, in order to describe the present invention in more detail, embodiments for carrying out the invention will be described with reference to the accompanying drawings. Embodiment 1.

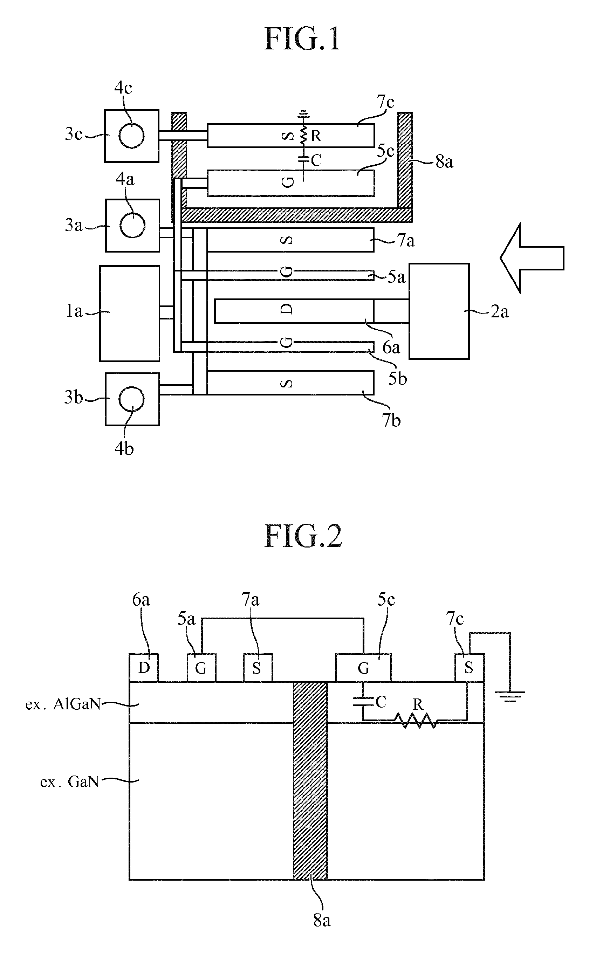

Fig. 1 is a layout diagram of an FET chip according to Embodiment 1 of the invention.

In Fig. 1, gate electrodes 5a to 5c are connected to a gate pad 1a.

A drain electrode 6a is connected to a drain pad 2a.

Source electrodes 7a and 7b are connected to source pads 3a and 3b, respectively, and a source electrode 7c is connected to a source pad 3c.

The source pads 3a to 3c are grounded through via holes 4a to 4c, respectively.

The gate electrodes 5a and 5b, the drain electrode 6a, and the source electrodes 7a and 7b configure one FET cell.

An isolation implantation part 8a electrically isolates the gate electrodes 5a and 5b, the drain electrode 6a, and the source electrodes 7a and 7b from the gate electrode 5c and the source electrode 7c.

For example, hydrogen, helium, or nitrogen is ion implanted into the isolation implantation part 8a to thereby perform element isolation.

Fig. 2 is a sectional view of a device as viewed from an arrow direction of Fig. 1.

A part between the gate electrode 5c and the source electrode 7a is electrically isolated by the isolation implantation part 8a, and therefore the drain electrode 6a, the gate electrode 5a, and the source electrode 7a are electrically isolated from the gate electrode 5c, and the source electrode 7c.

Additionally, a gate capacitance C is formed between the gate electrode 5c and two-dimensional electron gas.

Furthermore, a channel resistance R is formed between the gate electrode 5c and the source electrode 7c.

An RC circuit including these gate capacitance C and channel resistance R configures an oscillation suppression circuit.

Note that AlGaN and GaN, for example, are used for the inside of the FET chip.

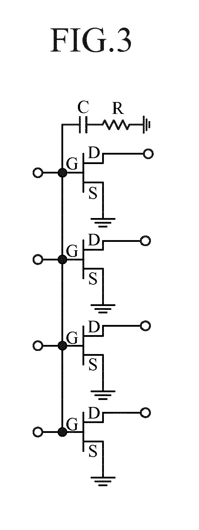

Fig. 3 is an equivalent circuit diagram of the FET chip.

While Fig. 1 shows only a configuration corresponding to one FET cell, Fig. 3 shows a configuration of four FET cells in which the respective electrodes are arranged at a plurality of locations in a direction orthogonal to the finger directions.

In this case, as shown in Fig. 3, the RC circuit is loaded on an outermost FET.

Now, an operation thereof will be described.

As shown in Fig. 21, in a case where a synthetic circuit is added to the FET chip to be used, the outer FET cell is far from the isolation resistor R, and therefore there is a possibility that loop oscillation occurs.

In this Embodiment 1, the RC circuit is loaded on the outer FET, and power is consumed by the channel resistance R, and therefore a loop gain with respect to the oscillation can be reduced, whereby the loop oscillation is suppressed.

Consequently, an unstable operation of the FET chip is prevented, and it can be produced by only an FET process without using an MMIC process, and therefore it is possible to attain reduction in cost and size.

As described above, according to this Embodiment 1, the oscillation suppression circuit including the RC circuit is loaded by only the FET process to thus make an MMIC design unnecessary, so that it is possible to attain stabilization of the FET while suppressing increase in cost, and to suppress the oscillation.

Moreover, no current flows between the gate electrode 5c and the source electrode 7c, and the other electrodes by the isolation implantation part 8a to thereby suppress an occurrence of a gate capacitance and/or a channel resistance to be unnecessary, whereby the stabilization of the FET can be achieved.

### Embodiment 2.

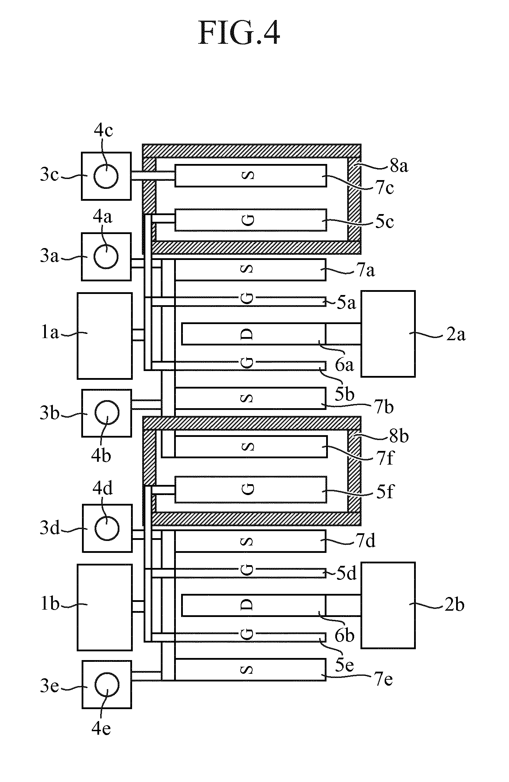

Fig. 4 is a layout diagram of an FET chip according to Embodiment 2 of the present invention.

In Fig. 4, gate electrodes 5d to 5f are connected to a gate pad 1b.

A drain electrode 6b is connected to a drain pad 2b.

Source electrodes 7d and 7d are connected to source pads 3d and 3e, respectively.

Source electrode 7f is also connected to a source pad 3b.

The source pads 3d and 3e are grounded through via holes 4d and 4e, respectively.

The gate electrodes 5d and 5e, the drain electrode 6b, and the source electrodes 7d and 7e configure one FET cell.

An isolation implantation part 8b electrically isolates the gate electrodes 5d and 5e, the drain electrode 6b, and the source electrodes 7d and 7e from the gate electrode 5f and the source electrode 7f.

The other configurations are identical with those of Embodiment 1. However, in Embodiment 2, an RC circuit is loaded on each FET cell.

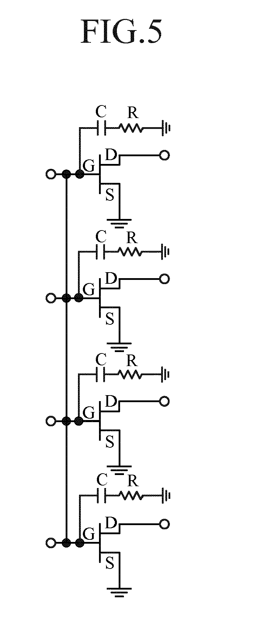

Fig. 5 is an equivalent circuit diagram of the FET chip.

The RC circuit is loaded in shunt for each FET cell.

Now, an operation thereof will be described.

A basic operation is identical with that of Embodiment 1. However, in this Embodiment 2, the RC circuit is loaded on each FET cell, and therefore stability is improved for not only an outer FET, but also the other FETs.

Consequently, an unnecessary oscillation of the FET chip can be more greatly suppressed as compared to Embodiment 1.

As described above, according to this Embodiment 2, an oscillation suppression circuit is loaded on each FET cell, and therefore the stability is improved for not only the outer FET, but also the other FETs. Consequently, it is possible to more greatly suppress the unnecessary oscillation of the FET chip as compared to Embodiment 1.

### Embodiment 3.

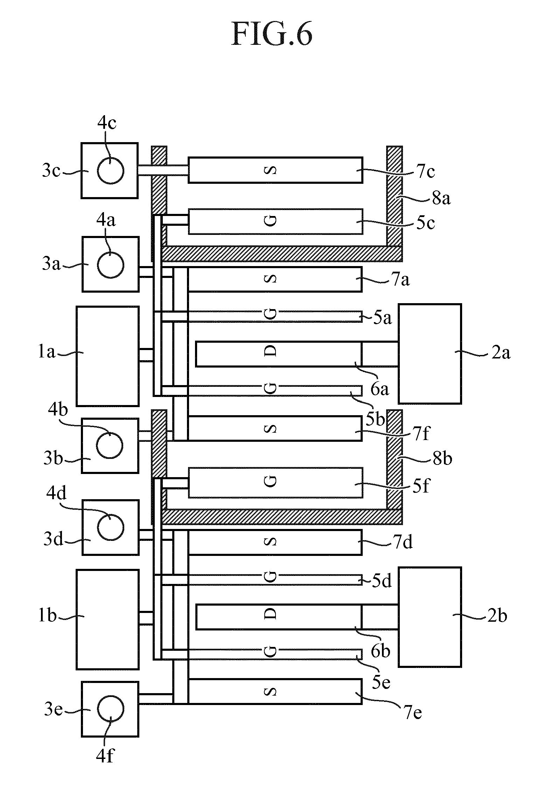

Fig. 6 is a layout diagram of an FET chip according to Embodiment 3 of the present invention.

While the source electrodes 7b and 7f are separately arranged in Fig. 4 shown in Embodiment 2, both the source electrodes 7b and 7f are shared to serve as one source electrode 7f in Fig. 6.

The other configurations are identical with those of Embodiment 2.

As described above, according to this Embodiment 3, it is possible to attain reduction in size of the FET chip while obtaining effects similar to those of Embodiment 2.

### Embodiment 4.

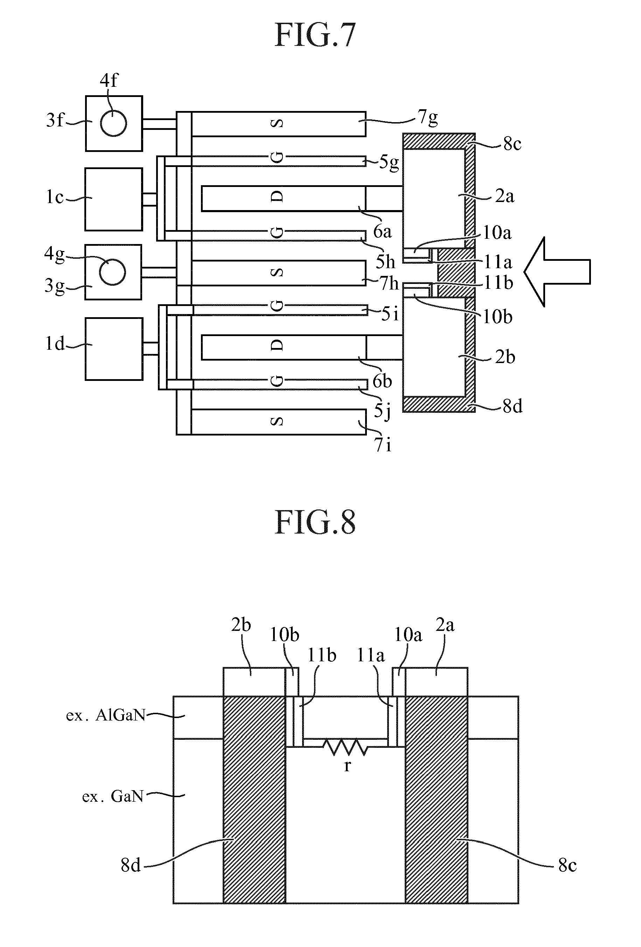

Fig. 7 is a layout diagram of an FET chip according to Embodiment 4 of the present invention.

In Fig. 7, gate electrodes 5g and 5h are connected to a gate pad 1c.

Gate electrodes 5i and 5j are connected to a gate pad 1d.

A drain electrode 6a is connected to a drain pad 2a, and a drain electrode 6b is connected to a drain pad 2b.

Source electrodes 7g to 7i are connected to source pads 3f and 3g.

The source pads 3f and 3g are grounded through via holes 4f and 4g, respectively.

The gate electrodes 5g and 5h, the drain electrode 6a, and the source electrodes 7g and 7h configure one FET cell.

Additionally, the gate electrodes 5i and 5j, the drain electrode 6b, and the source electrodes 7h and 7i configures another FET cell.

An isolation implantation part 8c is arranged so as to surround the drain pad 2a, and an isolation implantation part 8d is arranged so as to surround the drain pad 2b.

An electrode 10a is provided on the drain pad 2b side of the drain pad 2a, and an electrode 10b is provided on the drain pad 2a side of the drain pad 2b.

An ion implantation part 11a is provided on a lower layer of the electrode 10a, and an ion implantation part 11b is provided on a lower layer of the electrode 10b.

Consequently, it is regarded that the electrode 10a and the ion implantation part 11a are electrically connected, and that the electrode 10b and the ion implantation part 11b are electrically connected. Note that in the ion implantation, a group 4 element such as Si is used.

Fig. 8 is a sectional view of the inside of a semiconductor as viewed from an arrow direction of Fig. 7.

As mentioned previously, the electrode 10a and the ion implantation part 11a are electrically connected, the electrode 10b and the ion implantation part 11b are electrically connected, and there is a channel layer between the ion implantation parts 11a and 11b, and therefore the corresponding region appears as a channel resistance r.

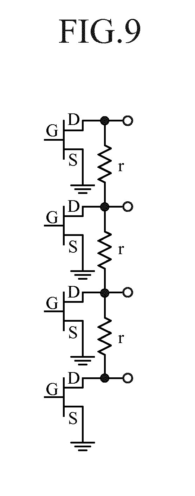

Accordingly, when expressed by an equivalent circuit, Fig. 7 is represented as Fig. 9.

The channel resistance r (isolation resistor: referred to as an oscillation suppression circuit) is connected between drain terminals of each FET cell.

With such an arrangement, loop oscillation is suppressed, and a stable operation of the FETs can be attained.

Moreover, it can be produced by only an FET process without using an MMIC process, and therefore the number of manufacturing processes is not increased to attain further reduction in cost.

As described above, according to this Embodiment 4, the oscillation suppression circuits can be loaded by only the FET process to thus make an MMIC design unnecessary, so that it is possible to attain stabilization of the FETs while suppressing increase in cost, and to suppress the oscillation.

Additionally, the isolation implantation parts 8c and 8d are arranged so as to surround the drain pads 2a and 2b, so that the channel resistances r can be more accurately produced.

### Embodiment 5.

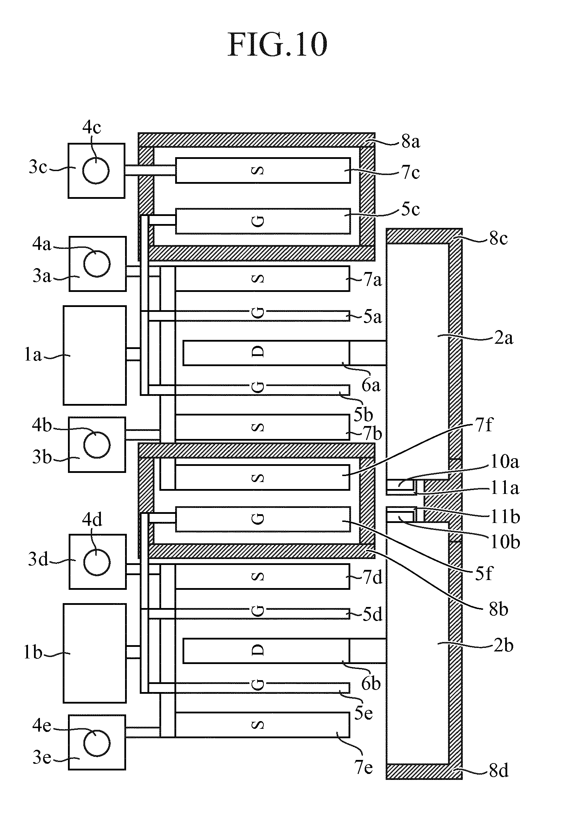

Fig. 10 is a layout diagram of an FET chip according to Embodiment 5 of the present invention.

Fig. 10 is crafted as a layout formed in combination of Embodiment 2 and Embodiment 4. A description for each reference numeral is the same as the above, and therefore is omitted.

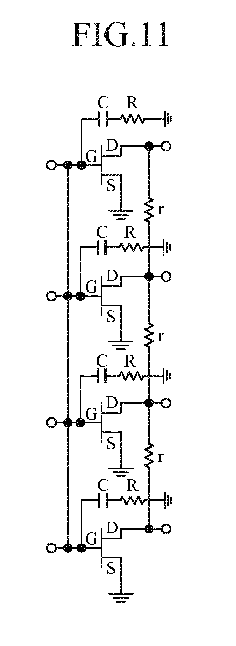

An equivalent circuit diagram of this layout is shown in Fig. 11.

An RC circuit on a gate side and an isolation resistor r on a drain side are loaded on each FET, and therefore loop oscillation and so on can be effectively suppressed, and the FETs can be more stably operated.

As described above, according to this Embodiment 5, oscillation suppression circuits can be loaded by only an FET process to make an MMIC design unnecessary, so that it is possible to attain stabilization of the FETs while suppressing increase in cost, and to more effectively suppress the oscillation.

### Embodiment 6.

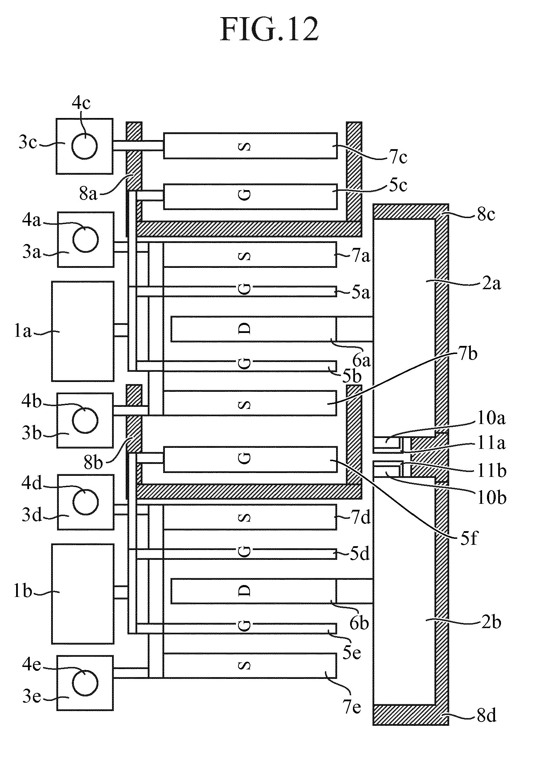

Fig. 12 is a layout diagram of an FET chip according to Embodiment 6 of the present invention.

While source electrodes 7b and 7f are separately arranged in Fig. 10 shown in Embodiment 5, both the source electrodes 7b and 7f are shared to serve as one source electrode 7f in Fig. 12.

The other configurations are identical with those of Embodiment 5.

As described above, according to this Embodiment 6, it is possible to attain reduction in size of the FET chip while obtaining effects similar to those of Embodiment 5.

### Embodiment 7.

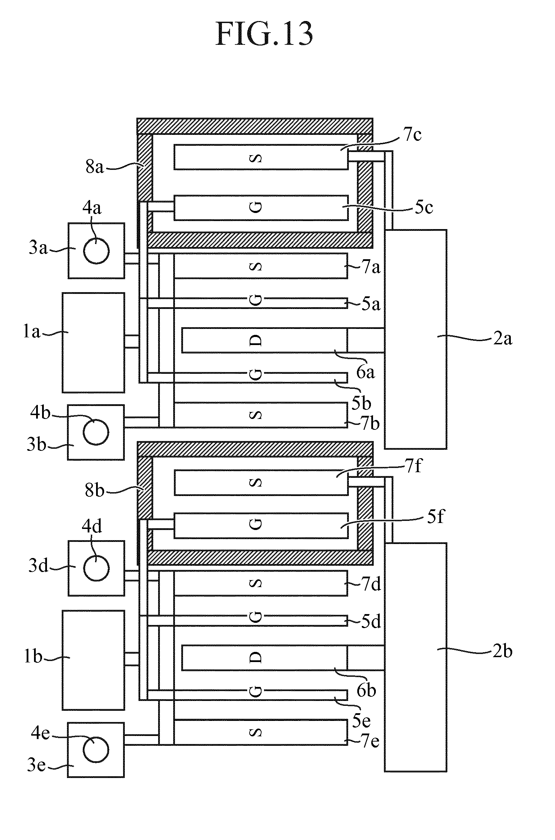

Fig. 13 is a layout diagram of an FET chip according to Embodiment 7 of the present invention.

In Fig. 13, a basic configuration approximates the configuration of Fig. 4 shown in Embodiment 2.

However, a source electrode 7c is connected to a drain pad 2a in place of a source pad 3c, and a source electrode 7f is connected to a drain pad 2b in place of a source pad 3b.

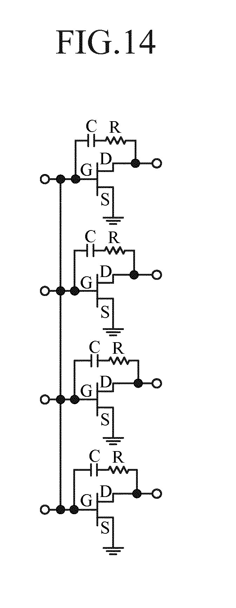

An equivalent circuit of Fig. 13 is shown in Fig. 14.

Channel resistances R form feedback resistances, and gate capacitances C form feedback capacitances.

Consequently, it is possible to attain stabilization of FETs.

Additionally, a wider bandwidth thereof can be attained by feeding back a part of output power.

As described above, according to this Embodiment 7, the channel resistances R function as the feedback resistances, and the gate capacitances C function as the feedback capacitances, and therefore the part of the output power is fed back by feedback circuits, so that the wider bandwidth can be attained.

Additionally, the stabilization of the FETs can be attained by the feedback circuits, and therefore the stability of the FETs is improved, so that a loop gain between FET cells is reduced, and stability with respect to loop oscillation is also improved (oscillation suppression circuit).

Accordingly, the oscillation suppression circuits can be loaded by only an FET process to make an MMIC design unnecessary, so that it is possible to attain the stabilization of the FETs while suppressing increase in cost, and to more effectively suppress the oscillation.

### Embodiment 8.

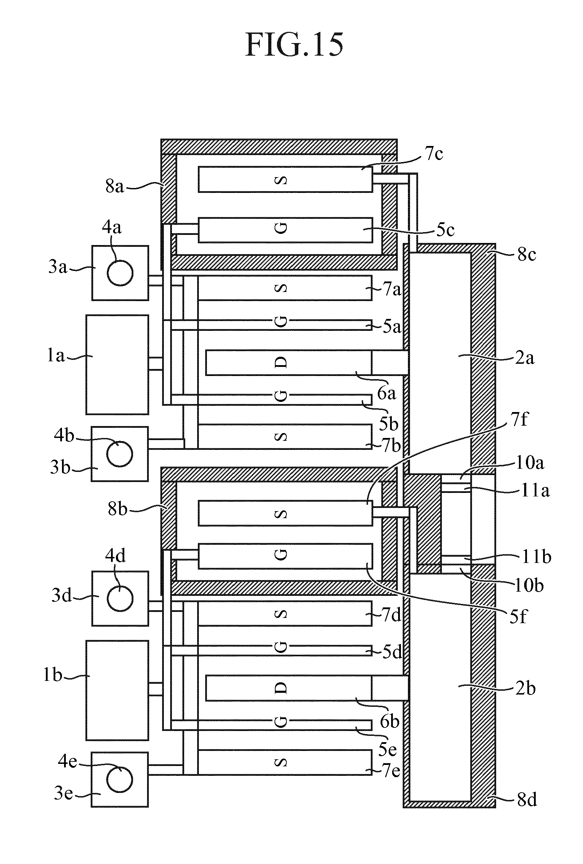

Fig. 15 is a layout diagram of an FET chip according to Embodiment 8 of the present invention.

In Fig. 15, a basic configuration approximates the configuration of Fig. 10 shown in Embodiment 5.

However, similarly to Embodiment 7, a source electrode 7c is connected to a drain pad 2a in place of a source pad 3c, and a source electrode 7f is connected to a drain pad 2b in place of a source pad 3b.

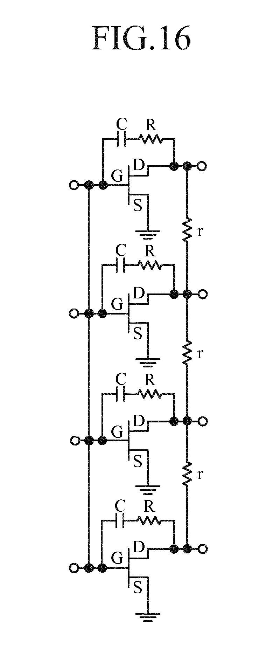

An equivalent circuit of Fig. 15 is shown in Fig. 16.

An isolation resistor r on a drain side is loaded on each FET, and therefore loop oscillation and so on can be effectively suppressed, and the FETs can be more stably operated.

Additionally, channel resistances R form feedback resistances, and gate capacitances C form feedback capacitances.

Consequently, it is possible to attain stabilization of the FETs.

Additionally, a wider bandwidth thereof can be attained by feeding back a part of output power.

As described above, according to this Embodiment 8, oscillation suppression circuits can be loaded by only a FET process to make an MMIC design unnecessary, so that it is possible to attain the stabilization of the FETs while suppressing increase in cost, and to more effectively suppress the oscillation.

Additionally, the channel resistances R function as the feedback resistances, and the gate capacitances C function as the feedback capacitances, and therefore the part of the output power is fed back by feedback circuits, whereby the wider bandwidth can be attained.

### Embodiment 9.

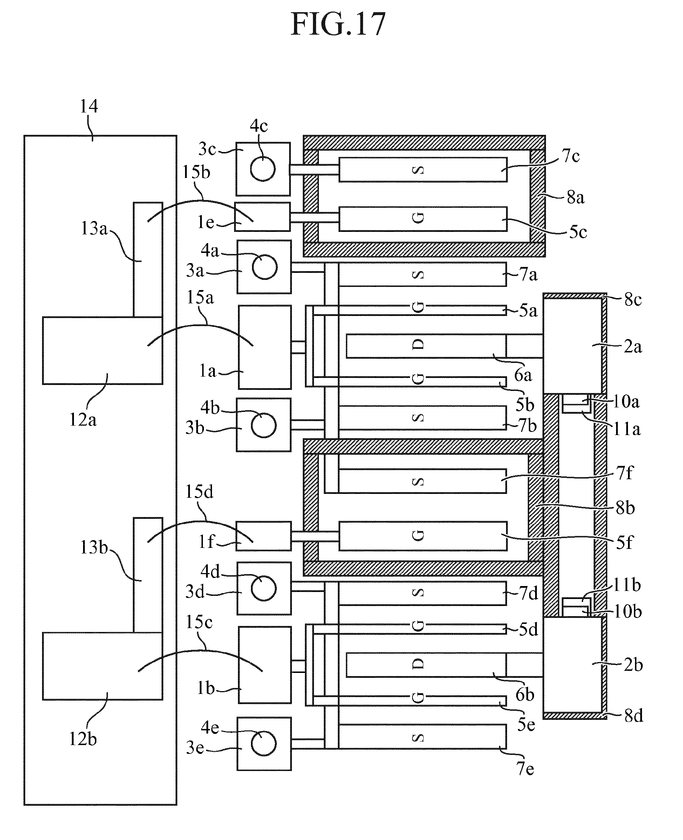

Fig. 17 is a layout diagram of an FET chip according to Embodiment 9 of the present invention.

In Fig. 17, a basic configuration approximates that of Fig. 10 shown in Embodiment 5.

However, a gate electrode 5c is connected to a gate pad 1e in place of a gate pad 1a, and a gate electrode 5f is connected to a gate pad 1f in place of a gate pad 1b.

Line patterns 12a and 13a are formed on a dielectric substrate 14 to have a substantially L-shape.

Line patterns 12b and 13b are similarly formed on the dielectric substrate 14 to have a substantially L-shape.

A wire 15a connects a gate pad 1a to a bent part of the substantially L-shaped line patterns 12a and 13a.

A wire 15b connects the gate pad 1e to an end of the line pattern 13a.

A wire 15c connects a gate pad 1b to a bent part of the substantially L-shaped line patterns 12b and 13b.

A wire 15d connects the gate pad 1f to an end of the line pattern 13b.

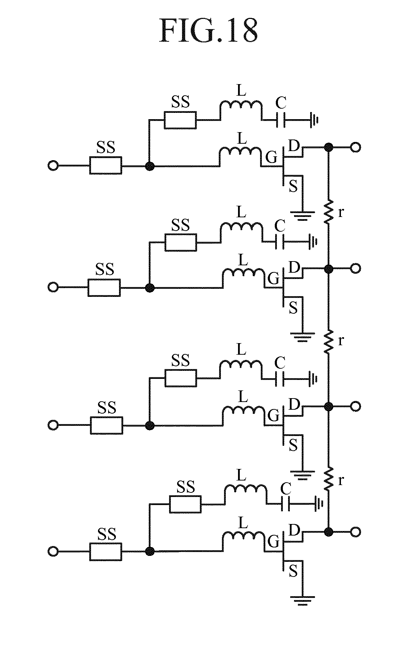

An equivalent circuit diagram of this Embodiment 9 is shown in Fig. 18.

In the aforementioned description, it is regarded that an RC circuit is loaded on each FET. However, for the sake of simplification of description, in this case, it shall be regarded as nearly a capacitance because of a small resistance component.

Thus, from an aspect of the equivalent circuit, it can be regarded as short stubs SS formed of line patterns, inductors L formed of wires, and capacitances C, and can be regarded as a sort of pre-match circuit.

The effects of isolation resistors r between drain pads 2a and 2b are the same as those of Embodiment 5. Consequently, matching is easily attained while loop oscillation is suppressed.

Note that even in a case where resistance components are present, it is the same that the corresponding circuits operate as a sort of pre-match circuit.

As described above, according to this Embodiment 9, it is possible to attain the matching while suppressing the loop oscillation by the pre-match circuit.

### Embodiment 10.

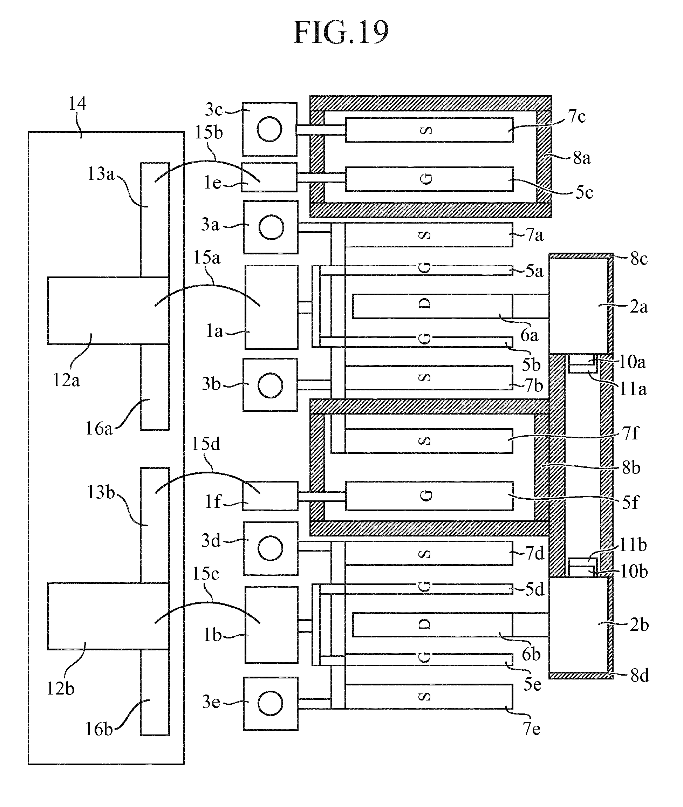

Fig. 19 is a layout diagram of an FET chip according to Embodiment 10 of the present invention.

In Fig. 19, a basic configuration approximates the configuration of Fig. 17 shown in Embodiment 9.

However, line patterns 12a, 13a and 16a are formed on a dielectric substrate 14 to have a substantially T-shape.

Line patterns 12b, 13b and 16b are similarly formed on a dielectric substrate 14 to have a substantially T-shape.

A wire 15a connects a gate pad 1a to an intersection part of the substantially T-shaped line patterns 12a, 13a, and 16a.

A wire 15c connects a gate pad 1b to an intersection part of the substantially T-shaped line patterns 12b, 13b, and 16b.

An equivalent circuit diagram of this Embodiment 10 is shown in Fig. 20.

In this Embodiment 10, from an aspect of an equivalent circuit, it can be regarded as open stubs OS and short stubs SS formed of line patterns, inductors L formed of wires, and capacitances C, and can be regarded as a pre-match circuit.

As described above, according to this Embodiment 10, it is possible to attain matching while suppressing loop oscillation by the pre-match circuit.

It is noted that in the present invention, a free combination in the embodiments, a modification of arbitrary components in the embodiments, or an omission of arbitrary components in the embodiments is possible within a range of the invention.

### INTUSTRIAL APPLICABILITY

An FET chip of the present invention is configured to include the oscillation suppression circuit that has a gate capacitance formed between the second gate electrode and two-dimensional electron gas, and the channel resistance between the second gate electrode and second source electrode, and therefore the oscillation suppression circuit can be loaded by only the FET process to make the MMIC design unnecessary, so that it is possible to attain the stabilization of the FET while suppressing increase in cost, and to suppress the oscillation.

### DESCRIPTION OF REFERENCE NUMERALS

- 1a to 1f: gate pads
- 2a, 2b: drain pads
- 3a to 3e: source pads
- 4a to 4e: via holes
- 5a to 5j: gate electrodes
- 6a, 6b: drain electrodes
- 7a to 7i: source electrodes
- 8a to 8d: isolation implantation parts
- 10a, 10b: electrodes
- 11a, 11b: ion implantation parts
- 12a, 12b, 13a, 13b, 16a, 16b: line patterns
- 14: dielectric substrate
- 15a to 15d: wires.

## Claims

1. An FET chip comprising:
a first gate electrode that is connected to a gate pad;
a second gate electrode that is connected to the gate pad;
a drain electrode that is connected to a drain pad;
a first source electrode that is connected to a first source pad grounded through a first via hole;
a second source electrode that is connected to a second source pad grounded through a second via hole;
an FET cell that includes the first gate electrode, the drain electrode, and the first source electrode;
an isolation implantation part that electrically isolates the first gate electrode, the drain electrode, and the first source electrode from the second gate electrode, and the second source electrode; and
an oscillation suppression circuit that includes a gate capacitance formed between the second gate electrode and two-dimensional electron gas, and a channel resistance between the second gate electrode and the second source electrode.

2. An FET chip having an FET chip according to claim 1 defined as one FET cell, wherein a plurality of the one FET cells are arranged therein.

3. The FET chip according to claim 2, wherein
in a case where a source electrode is arranged next to the second source electrode, both the source electrodes are shared to serve as one second source electrode.

4. An FET chip comprising:
a first gate electrode that is connected to a first gate pad;
a first drain electrode that is connected to a first drain pad;
a source electrode that is connected to a source pad grounded through a via hole;
a second gate electrode that is connected to a second gate pad;
a second drain electrode that is connected to a second drain pad;
a first FET cell that includes the first gate electrode, the first drain electrode, and the source electrode;
a second FET cell that includes the second gate electrode, the second drain electrode, and the source electrode;
a first electrode that is provided on the second drain pad side of the first drain pad;
a second electrode that is provided on the first drain pad side of the second drain pad;
a first ion implantation part that is provided on a lower layer of the first electrode;
a second ion implantation part that is provided on a lower layer of the second electrode; and
an oscillation suppression circuit that includes a channel resistance between the first ion implantation part and the second ion implantation part.

5. An FET chip comprising:
a first gate electrode that is connected to a first gate pad;
a second gate electrode that is connected to the first gate pad;
a first drain electrode that is connected to a first drain pad;
a first source electrode that is connected to a first source pad grounded through a first via hole;
a second source electrode that is connected to a second source pad grounded through a second via hole;
a third gate electrode that is connected to a second gate pad;
a fourth gate electrode that is connected to the second gate pad;
a second drain electrode that is connected to a second drain pad;
a third source electrode that is connected to a third source pad grounded through a third via hole;
a fourth source electrode that is connected to a fourth source pad grounded through a fourth via hole;
a first FET cell that includes the first gate electrode, the first drain electrode, and the first source electrode;
a second FET cell that includes the third gate electrode, the second drain electrode, and the third source electrode;
a first isolation implantation part that electrically isolates the first gate electrode, the first drain electrode, and the first source electrode from the second gate electrode, and the second source electrode;
a second isolation implantation part that electrically isolates the third gate electrode, the second drain electrode, and the third source electrode from the fourth gate electrode, and the fourth source electrode;
a first oscillation suppression circuit that includes a gate capacitance formed between the second gate electrode and two-dimensional electron gas, and a channel resistance between the second gate electrode and the second source electrode;
a second oscillation suppression circuit that includes a gate capacitance formed between the fourth gate electrode and two-dimensional electron gas, and a channel resistance between the fourth gate electrode and the fourth source electrode;
a first electrode that is provided on the second drain pad side of the first drain pad;
a second electrode that is provided on the first drain pad side of the second drain pad;
a first ion implantation part that is provided on a lower layer of the first electrode;
a second ion implantation part that is provided on a lower layer of the second electrode; and
a third oscillation suppression circuit that includes a channel resistance between the first ion implantation part and the second ion implantation part.

6. The FET chip according to claim 5, wherein
in a case where a source electrode is arranged next to the second source electrode, both the source electrodes are shared to serve as one second source electrode, and
in a case where a source electrode is arranged next to the fourth source electrode, both the both source electrodes are shared to serve as one fourth source electrode.

7. An FET chip comprising:
a first gate electrode that is connected to a gate pad;
a second gate electrode that is connected to the gate pad;
a drain electrode that is connected to a drain pad;
a first source electrode that is connected to a source pad grounded through a via hole;
a second source electrode that is connected to the drain pad;
an FET cell that includes the first gate electrode, the drain electrode, and the first source electrode;
an isolation implantation part that electrically isolates the first gate electrode, the drain electrode, and the first source electrode from the second gate electrode, and the second source electrode; and
an oscillation suppression circuit that includes a gate capacitance formed between the second gate electrode and two-dimensional electron gas, and a channel resistance between the second gate electrode and the second source electrode.

8. The FET chip according to claim 5, wherein
the second source electrode is connected to the first drain pad in place of the second source pad, and
the fourth source electrode is connected to the second drain pad in place of the fourth source pad.

9. The FET chip according to claim 5, wherein
the second gate electrode is connected to a third gate pad in place of the first gate pad, and
the fourth gate electrode is connected to a fourth gate pad in place of the second gate pad,
the FET chip further comprising:
a substantially L-shaped first line pattern that is formed on a dielectric substrate;
a substantially L-shaped second line pattern that is formed on the dielectric substrate;
a first wire that connects the first gate pad to a bent part of the first line pattern;
a second wire that connects the third gate pad to an end of the first line pattern;
a third wire that connects the second gate pad to a bent part of the second line pattern; and
a fourth wire that connects the fourth gate pad to an end of the second line pattern.

10. The FET chip according to claim 5, wherein
the second gate electrode is connected to a third gate pad in place of the first gate pad, and
the fourth gate electrode is connected to a fourth gate pad in place of the second gate pad,
the FET chip further comprising:
a substantially T-shaped first line pattern that is formed on a dielectric substrate;
a substantially T-shaped second line pattern that is formed on the dielectric substrate;
a first wire that connects the first gate pad to an intersection part of the first line pattern;
a second wire that connects the third gate pad to an end of the first line pattern;
a third wire that connects the second gate pad to an intersection part of the second line pattern; and
a fourth wire that connects the fourth gate pad to an end of the second line pattern.
